Europäisches Patentamt

European Patent Office

Office européen des brevets

(11) Numéro de publication: **0 195 701**
**B1**

(12) **FASCICULE DE BREVET EUROPEEN**

(45) Date de publication du fascicule du brevet:
**02.08.89**

(21) Numéro de dépôt: **86400414.8**

(22) Date de dépôt: **26.02.86**

(51) Int. Cl.⁴: **H05K 7/20**

(54) Agrafe multiple de fixation et dispositif de montage collectif de composants électroniques de puissance.

(30) Priorité: **07.03.85 FR 8503351**

(43) Date de publication de la demande:
**24.09.86 Bulletin 86/39**

(45) Mention de la délivrance du brevet:
**02.08.89 Bulletin 89/31**

(84) Etats contractants désignés:
**DE GB IT NL SE**

(56) Documents cités:
**US-A- 3 654 521**
**US-A- 4 288 839**

(73) Titulaire: **Bendix Electronics S.A., Avenue du Mirail,
B.P. 1149, F-31036 Toulouse Cédex(FR)**

(72) Inventeur: **Lacz, Alexandre, Auragne Chemin de Penot,
F-31190 Auterive(FR)**

(74) Mandataire: **Colas, Jean-Pierre et al, Cabinet de
Boisse 37, avenue Franklin D. Roosevelt,
F-75008 Paris(FR)**

## Description

La présente invention concerne une agrafe multiple de fixation destinée à être mise en place à force, par exemple par pression, pour assurer notamment le montage collectif de composants électroniques de puissance sur un même conducteur thermique. Elle concerne également un dispositif particulier de montage collectif de tels composants à l'aide de cette agrafe.

Le problème technique du montage de composants électroniques de puissance, connectés à un circuit imprimé, sur un conducteur thermique en vue de la dissipation de la chaleur en cours de fonctionnement du circuit est résolu actuellement selon deux méthodes guère satisfaisantes. La première consiste à visser chaque composant électronique de puissance à travers un conducteur thermique, après mise en place d'un canon isolant autour du trou percé dans le composant pour isoler la vis de fixation. En plus du fait que cette méthode de montage est unitaire donc onéreuse, elle présente deux principaux inconvénients :

Tout d'abord le cambrage de la semelle du composant, semelle généralement en cuivre, en raison de la non régularité de l'effort transmis au niveau de la vis de fixation. Ensuite, le fluage du canon isolant logé dans le trou du conducteur thermique au cours d'utilisation à températures élevées, entraînant une diminution de l'effort de vissage donc une mauvaise fixation du composant sur le conducteur thermique.

La seconde méthode consiste à fixer chaque composant de puissance sur le conducteur thermique à l'aide d'une agrafe transversale nécéssitant la réalisation de deux évidements de part et d'autre du composant pour son maintien. En plus de l'encombrement d'un tel dispositif de fixation, cette méthode est elle aussi unitaire donc coûteuse.

Il a également été proposé notamment dans le brevet US-A-3.654.521 un dispositif de fixation comportant une agrafe multiple réalisée à partir d'un bande de matériau thermiquement conducteur , découpée selon deux séries de créneaux le long des deux bords latéraux de la bande et pliée de part et d'autre de l'axe longitudinal de la bande de sorte qu'entre deux créneaux consécutifs est défini un élément de l'agrafe relié à l'élément suivant par un pontet, chaque élément comprenant un embase d'où partent deux branches. Dans ce dispositif la fixation des cartemodules n'est obtenue que par coopération d'une part de deux branches adjacentes longitudinalement mais n'appartenant pas au même élément d'agrafe, et d'autre part d'un matelas élastomère de remplissage. Une telle structure très complexe et onéreuse ne permet pas à chaque élément d'agrafe de travailler élastiquement de façon sensiblement autonome et de pouvoir ainsi fixer des composants électroniques d'épaisseur variable.

La présente invention a pour but de palier à ces inconvénients en proposant un montage collectif de plusieurs composants électroniques de puissance sur un conducteur thermique, de coût réduit et de fiabilité assurée.

Pour cela, l'objet de la présente invention est tout d'abord une agrafe multiple de fixation réalisée à partir d'une bande de matériau thermiquement conducteur, découpée selon deux séries de créneaux le long des deux bords latéraux de la bande et pliée de part et d'autre de l'axe longitudinal de la bande de sorte qu'entre deux créneaux consécutifs est défini un élément de l'agrafe relié à l'élément suivant par un pontet, chaque élément comprenant une embase d'où partent deux branches, l'agrafe étant caractérisée par le fait que les deux branches (8) et (9) se composent d'une première branche suivant le plan perpendiculaire à la partie centrale de l'embase et dont l'extrémité est recourbée vers l'extérieur de l'agrafe en forme de crochet, et d'une seconde branche suivant un plan incliné vers l'extrémité recourbée de la première branche et dont l'extrémité est aussi rabattue vers l'extérieur en forme de crochet, la première branche d'au moins deux éléments de l'agrafe comportant un picot dirigé vers l'intérieur de l'agrafe.

L'invention a ensuite pour objet un dispositif de montage collectif de composants électroniques de puissance sur un conducteur thermique au moyen d'une agrafe selon le paragraphe précédent, les composants électroniques étant connectés à un circuit imprimé et le conducteur thermique ainsi que ce circuit imprimé étant destinés à être montés dans un boîtier, caractérisé en ce qu'il comprend :

- un conducteur thermique en forme d'équerre, comportant une face percée d'une rangée de lumières parallèle à l'arête de l'équerre, et comportant des moyens de fixation au boîtier ;
- une plaque de matériau diélectrique, d'épaisseur uniforme, placée contre la face percée du conducteur thermique ;
- une agrafe mise en place par pression de part et d'autre de la face percée du conducteur thermique et des composants électroniques séparés de ce conducteur par la plaque diélectrique, les picots de l'agrafe étant encliquetés dans les lumières du conducteur thermique.

L'invention offre les avantages suivants : il est possible de monter sur un même conducteur thermique différents types de composants électroniques au moyen d'une même agrafe, de largeur et d'épaisseur différentes, que ces composants soient alignés serrés les uns à côté des autres ou espacés. De plus, l'isolant étant sous forme d'une plaque, celui-ci se met simplement en place par contact entre les composants et le conducteur thermique, et sans nécessiter un positionnement très précis.

D'autres caractéristiques et avantages de l'invention apparaîtront dans la description qui suit, illustrée par les figures suivantes qui représentent :

- la figure 1 : une vue de dessus d'une agrafe selon l'invention ;
- la figure 2a et 2b : une vue en perspective et une vue en section droite de la même agrafe selon l'invention ;
- la figure 3 : une vue éclatée en perspective d'un dispositif de montage collectif selon l'invention.

Les éléments portant les mêmes références dans les différentes figures remplissent les mêmes fonctions en vue des mêmes résultats.

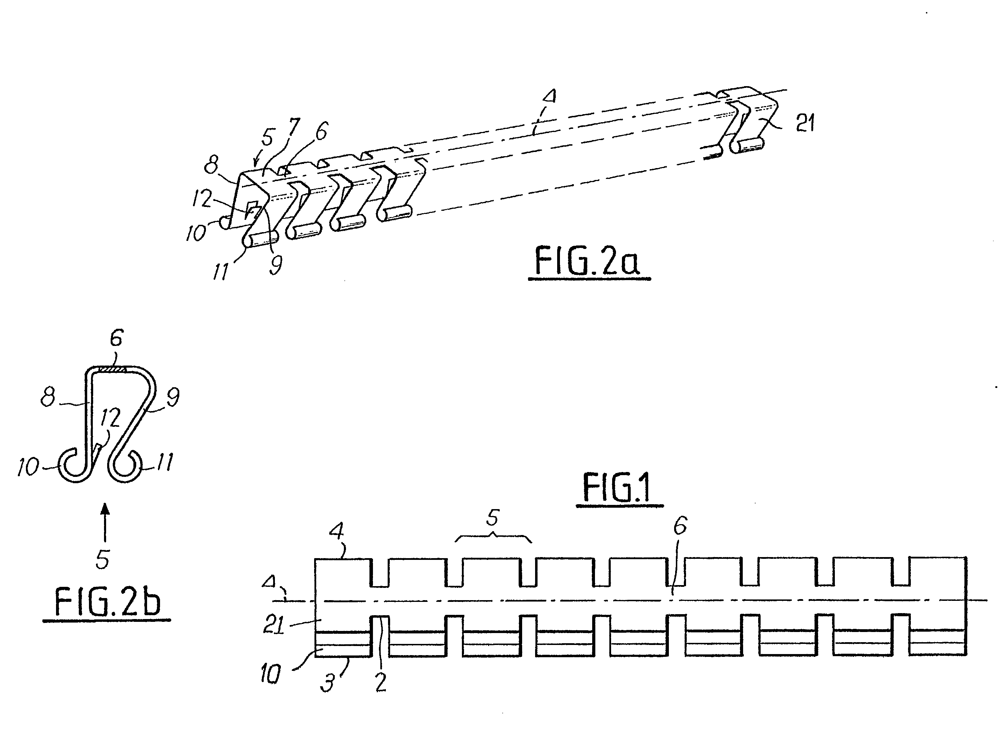

L'agrafe multiple de fixation 21 objet de l'invention est réalisée à partir d'une bande rectangulaire de matériau thermiquement conducteur découpée, pliée puis traitée. Ce matériau est généralement métallique, en alliage cuivre-berylium ou en acier trempé par exemple. Comme le montre la figure 1, cette bande a été découpée selon deux séries de créneaux 2 le long de ses deux bords latéraux 3 et 4. Cette bande a été ensuite pliée de part et d'autre de son axe longitudinal Δ de sorte que qu'entre deux créneaux 2 consécutifs est défini un élément 5 de l'agrafe. Deux éléments 5 consécutifs sont reliés par un pontet 6, dont la largeur permet d'assurer l'autonomie élastique de chaque élément 5 de la tenue mécanique de l'ensemble de l'agrafe.

Les figures 2a et 2b représentent respectivement une vue en perspective et une vue selon une section droite de l'agrafe 21. La bande précédemment décrite a été pliée de part et d'autre de l'axe de sorte que chaque élément 5 soit susceptible de fixer de façon indépendante ou autonome un composant électronique et comprenne une embase 7 d'où partent deux branches élastiques 8 et 9, une première branche 8 suivant un plan perpendiculaire à la partie centrale de l'embase et dont l'extrémité 10 est recourbée vers l'extérieur de l'agrafe en forme de crochet. La seconde branche 9 est inclinée vers cette extrémité recourbée 10 de la première branche 8 et possède elle-même une extrémité 11 en forme de crochet recourbé vers l'extérieur de l'agrafe. De plus, la première branche 8 de chaque élément 5 comporte un picot 12 dirigé vers l'intérieur de l'agrafe. Dans un autre mode de réalisation de l'invention non représenté seuls deux éléments (5) de l'agrafe comportent un picot 12.

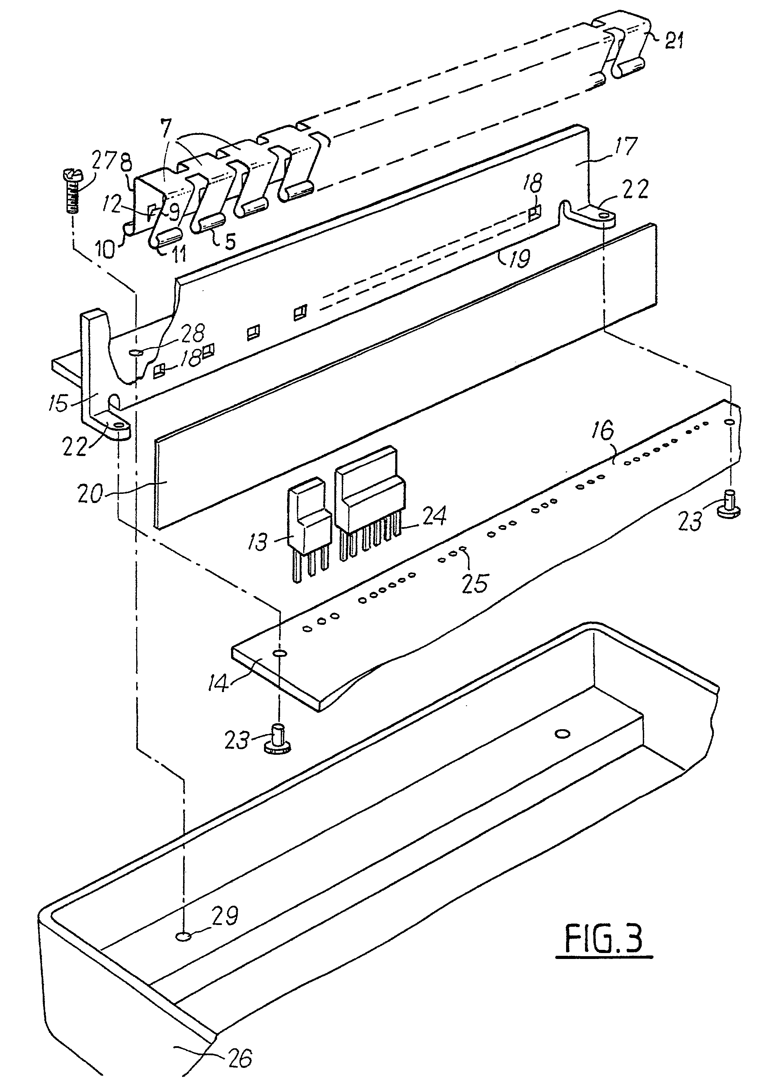

La figure 3 montre une vue éclatée du dispositif de montage de composants électroniques à l'aide d'une agrafe multiple (21) telle qu'elle vient d'être décrite. Il s'agit de fixer des composants électroniques de puissance 13, destinés à être connectés à un circuit imprimé 14, à un conducteur thermique 15 dont la fonction est de dissiper la chaleur produite par les composants lors de leur fonctionnement. Ces composants 13 de puissance seront pour cela placés à un bord 16 du circuit imprimé pour assurer une bonne dissipation thermique à l'extérieur du circuit.

Le dispositif de montage collectif des composants de puissance, selon l'invention, comporte tout d'abord un conducteur thermique 15 en forme d'équerre dont une des faces 17 est percée d'une rangée de lumières 18 parallèle à l'arête 19 de l'équerre. Dans le cas présent les lumières 18 sont équidistantes pour recevoir les picots 12 de l'agrafe 21. Le dispositif comporte de plus une plaque 20 de matériau diélectrique, d'épaisseur uniforme et enfin l'agrafe 21.

Les composants de puissance 13, destinés à être connectés au circuit imprimé 16, par des trous 25 métallisés par exemple, sont placés contre la face 17 du conducteur thermique 15, mais séparés d'elle par la plaque diélectrique 20 dont la fonction est l'isolation électrique entre la semelle des composants 13 et le conducteur 15 généralement métallique, sans gêner la dissipation thermique.

L'agrafe 21 déformable élastiquement est mise en place à force, par pression, de part et d'autre de la face percée 17 du conducteur thermique et des composants 13. La partie en équerre de l'agrafe, réalisée par l'embase 7 et la branche 8 de chaque élément 5, permet le positionnement en hauteur de l'agrafe sur le conducteur thermique et sa partie inclinée constituée par l'embase 7 et la branche 9 permet le placage des composants 13 contre le conducteur 15.

L'immobilisation de l'agrafe est assurée par l'encliquetement des picots 12 dans les lumières 18 du conducteur thermique, ces picots étant dirigés vers l'embase de l'agrafe de sorte qu'ils s'opposent à son enlèvement. Les extrémités recourbées 10 et 11 de l'agrafe servent à l'écartement des branches 8 et 9 au moyen d'une pince à becs, au moment de la mise en place de l'agrafe ou dans le but de l'ôter.

la plaque isolante 20, de forme rectangulaire sans ouverture, peut être obtenue par découpe d'une feuille de mica. Elle est de même longueur que le conducteur thermique 15 pour faciliter un centrage visuel dans le sens horizontal.

Le conducteur thermique 15 en forme d'équerre peut être réalisé à partir d'une plaque de cuivre ou aluminium par exemple, découpée et pliée. Il comporte deux pattes 22, perpendiculaires à la face percée 17, percées d'un trou destiné à coopérer avec une vis ou un rivet 23 de fixation du conducteur au circuit imprimé 14. Ces deux pattes 22 servent de plus de butée à la plaque diélectrique 20, pour son positionnement vertical. Pour assurer le maintien de cette plaque diélectrique 20 sur le conducteur thermique 15, lors du montage, elle est enduite au moins partiellement sur une face d'une graisse conductrice à base de silicone.

Ainsi, une fois les composants de puissance 13 maintenus par pression au moyen de l'agrafe 21 contre le conducteur thermique 15, cet ensemble est placé au dessus du circuit imprimé 14 de façon à ce que les connexions 24 de chaque composant 13 viennent se loger dans les trous métallisés 25 du circuit 14. Le conducteur thermique 15 est alors fixé au circuit imprimé par des rivets 23 et l'ensemble peut être passé au dessus du bain de soudure, selon un procédé classique de soudage à la vague.

Généralement un circuit imprimé est placé dans un boîtier protecteur, pouvant de plus jouer le rôle de radiateur thermique.

Dans ce cas, des moyens de fixation du conducteur thermique 15 à un boîtier 26 sont également prévus. Ces moyens de fixation sont par exemple des vis 27 destinées à coopérer avec des trous 28 et 29 pratiqués respectivement dans le conducteur 15 et le boîtier 26.

Ainsi, l'invention permet le montage collectif de composants électroniques de puissance sur un même conducteur thermique, dont le coût est réduit par rapport aux montages unitaires de l'art antérieur et dont la fiabilité est accrue.

**Revendications**

1. Agrafe multiple de fixation réalisée à partir d'une bande de matériau thermiquement conducteur,

découpée selon deux séries de créneaux (2) le long des deux bords latéraux (3 et 4) de la bande et pliée de part et d'autre de l'axe longitudinal (Δ) de la bande de sorte qu'entre deux créneaux consécutifs (2) est défini un élément (5) de l'agrafe relié à l'élément suivant par un pontet (6), chaque élément comprenant une embase (7) d'où partent deux branches (8 et 9), l'agrafe étant caractérisée par le fait que les deux branches (8) et (9) se composent d'une première branche (8) suivant un plan perpendiculaire à la partie centrale de l'embase (7) et dont l'extrémité (10) est recourbée vers l'extérieur de l'agrafe en forme de crochet, et d'une seconde branche (9) suivant un plan incliné vers l'extrémité (10) recourbée de la première branche (8) et dont l'extrémité (11) est aussi rabattue vers l'extérieur en forme de crochet, la première branche (8) d'au moins deux éléments (5) de l'agrafe comportant un picot (12) dirigé vers l'intérieur de l'agrafe.

2. Agrafe selon la revendication 1, caractérisée en ce qu'elle est réalisée à partir d'une bande en alliage cuivre-berylium ou en acier.

3. Dispositif de montage collectif de composants électroniques de puissance sur un conducteur thermique au moyen d'une agrafe (21) selon l'une des revendications 1 et 2, les composants électroniques étant destinés à être connectés à un circuit imprimé, caractérisé en ce qu'il comprend :

– un conducteur thermique (15) en forme d'équerre, comportant une face (17) percée d'une rangée de lumières (18) parallèle à l'arête (19) de l'équerre et comportant des moyens de fixation au circuit imprimé (14) ;

– une plaque (20) de matériau diélectrique, d'épaisseur uniforme, placée contre la face percée (17) du conducteur thermique (15) ;

– une agrafe (21) mise en place par pression de part et d'autre de la face percée (17) du conducteur thermique (15) et des composants électroniques (13) séparés de ce conducteur par la plaque diélectrique (20), les picots (12) de l'agrafe étant encliquetés dans les lumières (18) du conducteur thermique (15).

4. Dispositif selon la revendication 3, caractérisé en ce que les moyens de fixation du conducteur thermique (15) au circuit imprimé (14) auquel sont connectés les composants (13) sont constitués par deux pattes (22) disposées aux deux extrémités du conducteur (15) et percées chacune d'un trou destiné à coopérer avec une vis ou rivet (23) passant à travers le circuit imprimé (14).

5. Dispositif selon l'une des revendications 3 et 4, caractérisé en ce que l'ensemble constitué par les composants (13) connectés au circuit imprimé (14) et par le conducteur thermique (15) est logé dans un boîtier protecteur (26) servant de radiateur thermique.

6. Dispositif selon la revendication 3, caractérisé en ce que la plaque isolante (20) est en mica, de même longueur que le conducteur thermique (15).

**Patentansprüche**

1. Mehrfachbefestigungsklammer, gewonnen aus einem Streifen aus thermisch leitendem Material, der entlang seinen beiden Seitenkanten (3 und 4) so beschnitten wird, daß zwei Reihen von Lücken (2) entstehen, und der zu beiden Seiten seiner Längsachse (Δ) so gebogen wird, daß zwischen zwei aufeinanderfolgenden Lücken (2) ein Element (5) der Klammer entsteht, das mit dem nächstfolgenden Element über eine Brücke (6) verbunden ist, wobei jedes Element eine Fußfläche (7) umfaßt, von der zwei Äste (8 und 9) ausgehen, wobei diese Klammer dadurch gekennzeichnet ist, daß die beiden Äste (8) und (9) aus einem ersten Ast (8) bestehen, der in einer Ebene liegt, die zum mittleren Teil der Fußfläche (7) senkrecht verläuft, und dessen Ende (10) zum äußeren Teil der Klammer hin in Form eines Hakens gebogen ist; sowie aus einem zweiten Ast (9), der in einer Ebene liegt, die in Richtung auf das gebogene Ende (10) des ersten Astes (8) geneigt ist, und dessen Ende (11) ebenfalls nach außen in Form eines Hakens umgeschlagen ist, wobei der erste Ast (8) mindestens zweier Elemente (5) der Klammer über einen Zahn (12) verfügt, der zum Inneren der Klammer weist.

2. Klammer gemäß Anspruch 1, dadurch gekennzeichnet, daß sie aus einem Streifen aus einer Kupfer-Beryllium-Legierung bzw. aus Stahl gewonnen wird.

3. Vorrichtung zum gemeinsamen Zusammensetzen von elektronischen Leistungsbestandteilen auf einem Wärmeleiter mit Hilfe einer Klammer (21) gemäß einem der Ansprüche 1 und 2, wobei die elektronischen Bestandteile mit einer gedruckten Schaltung verbunden werden sollen, dadurch gekennzeichnet, daß die Vorrichtung folgendes umfaßt:

– einen Wärmeleiter (15) in Form eines Winkelbandes, dessen eine Seite (17) mit einer Reihe von Öffnungen (18) versehen ist, die parallel zur Kante (19) des Winkelbandes liegen, und der über Mittel zum Befestigen an der gedruckten Schaltung (14) verfügt;

– eine Platte (20) aus dielektrischem Material von gleichförmiger Dicke, die sich auf der durchbrochenen Fläche (17) des Wärmeleiters (15) befindet;

– eine Klammer (21), die durch Druck auf beiden Seiten der durchbrochenen Fläche (17) des Wärmeleiters (15) und der elektronischen Bestandteile (13) eingesetzt wird, die von diesem Leiter durch die dielektrische Platte (20) getrennt sind, wobei die Zähne (12) der Klammer in den Öffnungen (18) des Wärmeleiters (15) einrasten.

4. Vorrichtung gemäß Anspruch 3, dadurch gekennzeichnet, daß die Mittel zum Befestigen des Wärmeleiters (15) an der gedruckten Schaltung (14), mit der die Bestandteile (13) verbunden sind, aus zwei Klauen (22) bestehen, die sich an den beiden Enden des Leiters (15) befinden, und die jeweils über eine Öffnung verfügen, die mit einer Schraube bzw. einer Niete (23) zusammenwirken soll, die die gedruckte Schaltung (14) durchquert.

5. Vorrichtung gemäß einem der Ansprüche 3 und 4, dadurch gekennzeichnet, daß das Ganze, bestehend aus den mit der gedruckten Schaltung (14) verbundenen Bestandteilen (13) und aus dem Wärmeleiter (15), in einem Schutzgehäuse (26) untergebracht ist, das als Wärmestrahler dient.

6. Vorrichtung gemäß Anspruch 3, dadurch gekennzeichnet, daß die Isolierplatte (20) aus Glimmer besteht und die gleiche Länge wie der Wärmeleiter (15) aufweist.

**Claims**

1. Multiple fastening clip made from a strip of thermally conductive material, cut out to form two series of crenels (2) along the two long sides (3 and 4) of said strip and folded on either side of the longitudinal axis (Δ) of said strip in such a manner that between two consecutive crenels (2) there is defined an element (5) of the clip connected to the following element by a bridge (6), each element comprising a base (7) and two depending branches (8, 9), the clip being characterized in that the two branches (8) and (9) are comprised of a first branch (8) in a plane perpendicular to the central portion of base (7) with its end (10) curved towards the outside of the clip to form a hook, and of a second branch (9) in a plane inclined towards said curved end (10) of the first branch (8), with its end (11) likewise folded over outwardly to form a hook, the first branch (8) of at least two elements (5) of the clip being provided with a projection (12) directed towards the interior of the clip.

2. Clip according to Claim 1a, characterized in that it is made from a strip of cuproberyllium alloy or steel.

3. Device for the collective mounting of electronic power components on a heat sink with a clip (21) according to Claim 1 or 2, the electronic components being intended to be connected to a printed circuit, characterized in that it comprises:

   – a heat sink (15) having a square angle section, provided with one face (17) perforated by a row of apertures (18) parallel to the edge (19) of said angle section, and provided with means for fastening to said printed circuit (14);

   – a sheet (20) of dielectric material of uniform thickness, placed against said perforated face (17) of said heat sink (15);

   – a clip (21) resiliently placed in position to embrace the perforated face (17) of said heat sink (15) and said electronic components (13) separated from said heat sink by said dielectric sheet (20), said projections (12) of said clip (21) being clipped into said apertures (18) in said heat sink (15).

4. Device according to Claim 3, characterized in that said means for fastening said heat sink (15) to said printed circuit to which said components (13) are connected consist of two lugs (22) disposed at the two ends of said heat sink (15) and each perforated with a hole for cooperation with a screw or a rivet (23) passing through said printed circuit (14).

5. Device according to Claim 3 or 4, characterized in that the assembly consisting of said components (13) connected to said printed circuit (14) and of said heat sink (15) is housed in a protective casing (26) also serving as thermal radiator.

6. Device according to Claim 3, characterized in that said insulating sheet (20) is of mica, of the same length as said heat sink (15).

FIG.2a

FIG.2b

FIG.1

EP 0 195 701 B1

FIG.3